# EUROPEAN PATENT APPLICATION

(11) **EP 4 746 206 A1**
(43) Date of publication of application: **20.05.2026**
(21) Application number: 25216985.9
(22) Date of filing: 19.11.2025
(51) Int. Cl.: H01R 12/58, H05K 1/18, H10W 74/01, H10W 40/25, H10W 70/05, H10W 70/60, H10W 90/00, H10W 74/10, H05K 1/184

(54) **ENCAPSULATED SEMICONDUCTOR PACKAGE**

(30) Priority: 19.11.2024 NL 2039114
(71) Applicant: Nexperia B.V., 6534 AB Nijmegen (NL)
(72) Inventor: Minotti, Agatino, Catania (IT); Gong, Wei, Manchester (GB)
(74) Representative: Pjanovic, Ilija

(57) **Abstract**

An encapsulated semiconductor package is proposed, comprising a plurality of rivets, and a plurality of connection pins, each connection pin having a pin tip and a pin end, wherein the plurality of rivets are disposed in the encapsulant of the encapsulated semiconductor package, each rivet having a first rivet end and a second rivet end, each rivet being electrically mounted with a first rivet end on a corresponding bond pad of the semiconductor package; each rivet comprises a rivet cavity configured to receive the pin tip of the connection pin; the pin tip of the connection pin is configured as a press-fit pin tip having an outer diameter larger than an inner diameter of the rivet cavity and configured for friction-based engagement with the rivet cavity.

## Description

### Technical Field

The present disclosure relates to semiconductor packages having a connection pin, more specifically using a rivet for receiving the connection pin.

### Background

Power module designs incorporating encapsulated semiconductor package connection pins on the top surface, installed using rivets, offer the primary benefit of simplifying the connection to the gate driver board. Additionally, these solutions enhance overall system performance and reliability. This design approach helps reduce the distance between the gate driver and the power module, effectively minimizing the parasitic inductance in the control loop.

However, achieving a precise flush application of the Epoxy Moulding Compound (EMC) during the power module's formation process remains challenging. The interference fit between the pin and the rivet, for low electric resistance, can lead to increased material stress on the EMC.

Design of the electrical connections of the package realized by connecting pins and rivets may be required so that the rivets remain within the non-EMC parts of the package, which contributes to the complexity of the design.

### Summary

It would be advantageous to achieve an encapsulated semiconductive package comprising interference fit pins and rivets embedded in the EMC material without increasing its stresses.

According to an aspect of the present disclosure, there is provided an encapsulated semiconductor package comprising a plurality of rivets, and a plurality of connection pins, each connection pin having a pin tip and a pin end, wherein the plurality of rivets are disposed in the encapsulant of the encapsulated semiconductor package, and each rivet having a first rivet end and a second rivet end. The rivet is electrically mounted with a first rivet end on a corresponding bond pad of the semiconductor package. Each rivet comprises a rivet cavity configured to receive the pin tip of the connection pin. The pin tip of the connection pin is configured as a press-fit pin tip having an outer diameter larger than an inner diameter of the rivet cavity and configured for friction-based engagement with the rivet cavity.

It has been foundthat it may be beneficial to use a rivet which may be provided on the bond pad of the semiconductor package. This rivet comprises a rivet cavity which is provided to receive the connection pin. The connection pin may provide a power or a signal to the semiconductor package and is arranged to conduct current. To reduce stresses in the EMC resulting from the interference connection between pin and rivet, the use of a pin configured as a press-fit is proposed. Thus, the stresses caused by the connection are reduced by the prone geometry of the press-fit pin tip.

In an example of the disclosure the pin end of the connection pin is configured as a press-fit pin.

It may be beneficial to provide a double-sided press-fit connection. Double-sided press-fit connections will make it easier to install and remove the semiconductive package with a power module, considering that less force is required to remove the pins from the rivets.

In an example of the disclosure, the pin tip of the connection pin is configured as a press-fit pin with at least one hole-shaped sub-part and/or at least one bifurcated-shaped sub-part and/or at least one stamping-shaped sub-part and/or at least one pit-shaped sub-part.

It has been foundthat it may also be beneficial to provide the connection pin with a pin tip configured as a hole-shaped or bifurcated-shaped stamping-shaped press-fit pin tip, which configurations provide the most stable electrical connection while minimising stresses in the EMC caused by a press-fit connection.

It may also beneficial to provide the pin tip of the connection pin configured as a double press-fit pin tip. This may be beneficial as the connection pin may not be verticalized and stable using a single press-fit pin tip to connect to the rivet. The double press-fit pin has two points of connection on the rivet that may provide a vertical and more stable position for the connection pin.

In an example of the disclosure, the rivet is made of an electrically conductive material for providing an electrical connection between the bond pad and the connection pin.

It may be important to provide an electrically conductive material for the rivet, as it allows an electrical connection between the connection pin and the bond pad. This may be beneficial as the connection pin may not be connected, i.e. touching, to said bond pad. Then therefore, to still provide electrical connection between the connection pin and the bond pad, the rivet may comprise electrically conductive material.

In an example of the disclosure, the connection pin has a collar configured for abutment against the rivet.

A pin with a broadened diameter designed for abutment against a surface is commonly described as having a collar, flange or shoulder. This broadening also often called a "shoulder", "head", or "flange" provides a stable, larger surface area that improves the load distribution and prevents the pin from passing through a material or structure. It has been foundthat it may beneficial to provide the connection pin with the collar. This may be beneficial as the connection pin may not be properly positioned in a vertical and stable manner, using the press-fit pin tip to connect to the rivet. The collar of the connecting pin seated on the second rivet end may provide a vertical and more stable position for the pin with the prone end. This design can help distribute stress over a wider area, resist shear forces, and secure components in place without requiring additional fasteners.

In an example of the disclosure the rivet is pillar shaped with a circumferential groove near the second rivet end.

It may be provided the pillar-shaped rivet with a groove, whose shape and soldering joint is sufficient for press-fit connections between the rivet and the pin. This may be beneficial as the pillar-shaped rivet requires less energy in the soldering process.

In an example of the disclosure the rivet is barrel shaped or configured as a double flat-head rivet.

It has been foundthat it may also beneficial to provide different types of rivets - the barrel-shaped or double flat-head rivets - which also offers several advantages such as enhanced mechanical stability, higher pull-out resistance, ease of alignment and installation, and reduced stress concentration on encapsulant material.

Both the barrel or double flat-head shape provides a larger contact area at each end of the rivet, which helps distribute mechanical stress across a wider surface. This design effectively reduces the risk of loosening under pressure or vibration, ensuring greater mechanical stability for the semiconductor package.

The double flat-head rivet's structure improves its retention within the package, making it more resistant to pull-out forces. The broader end surface creates a strong anchoring effect, which is especially valuable in applications where high-strength fixation is required. It is also provides stable points of contact for easier alignment during assembly. This design also helps keep the rivet in a vertical position within the package, enhancing the stability of the connection pins and improving the assembly process. The increased contact area of the double flat-head design helps disperse stress around the rivet, minimizing stress concentration on the encapsulant material (such as EMC). This can improve the longevity of the package and enhance its reliability by reducing the potential for material deformation.

In an example of the disclosure, the encapsulated semiconductor package has a moulding compound being an Epoxy Moulding Compound, EMC.

It may be beneficial to provide the semiconductor package with an EMC, as it provides a strong adhesion to the surfaces of the semiconductor package. This ensures that the encapsulated package is protected within the moulded compound, preventing moisture ingress and mechanical failure.

In an example of the disclosure, the semiconductor package comprises any of: Metal-Oxide-Semiconductor, MOS, Field-Effect-Transistor, FET; Bipolar, Junction, Transistor, BJT; Diode.

It has been found that it may also beneficial to provide different types of semiconductor components (MOSFETs, BJTs, and diodes). Different types of semiconductor components can be used across a wide range of applications, including switching, amplification, and rectification. This versatility allows engineers to choose the most suitable component for specific electrical requirements, increasing the applicability of the package.

### Brief description of the figures

Fig. 1 depicts an encapsulated semiconductor package, without connection pins.
Fig. 2 depicts an encapsulated semiconductor package, comprising connection pins configured as a hole-shaped press-fit pin with collar.
Fig. 3 depicts an encapsulated semiconductor package, comprising connection pins configured as a hole-shaped press-fit pin tip and a pit-shaped press-fit pins end with a collar.
Fig. 4 depicts an encapsulated semiconductor package, comprising connection pins configured as a hole-shaped press-fit pin tip and a pit-shaped press-fit pin end with a collar.
Fig. 5 depicts an encapsulated semiconductor package, comprising connection pins configured as a bifurcated-shaped press-fit with a collar.
Fig. 6 depicts a pillar-shaped rivet.
Fig. 7 depicts a connection pin configured as a double press-fit pin with stamping-shaped pin end and pin tip.

### Detailed description

It is noted that in the description of the figures, same reference numerals refer to the same of similar components performing a same of essentially similar function.

A more detailed description is made with reference to particular examples, some of which are illustrated in the appended drawings, such that the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

The ensuing description above provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Unless the context clearly requires otherwise, throughout the description and the claims, the words "comprise", "comprising" and the like are to be construed in an inclusive sense, as opposed to an exclusive or exhaustive sense; that is to say, in the sense of "including, but not limited to". As used herein, the terms "connected", "coupled" or any variant thereof means any connection, either direct or indirect, between two or more elements; the connection between the elements can be physical, logical, electromagnetic, or a combination thereof. Additionally, the words "herein", "above", "below", and words of similar import, when used in this application, refer to this application as a whole and not to any particular portions of this application. Where the context permits, words in the Detailed Description using the singular or plural number may also include the plural or singular number respectively. The word "or" in reference to a list of two or more items, covers all the following interpretations of the word: any of the items in the list, all of the items in the list, and any combination of the items in the list.

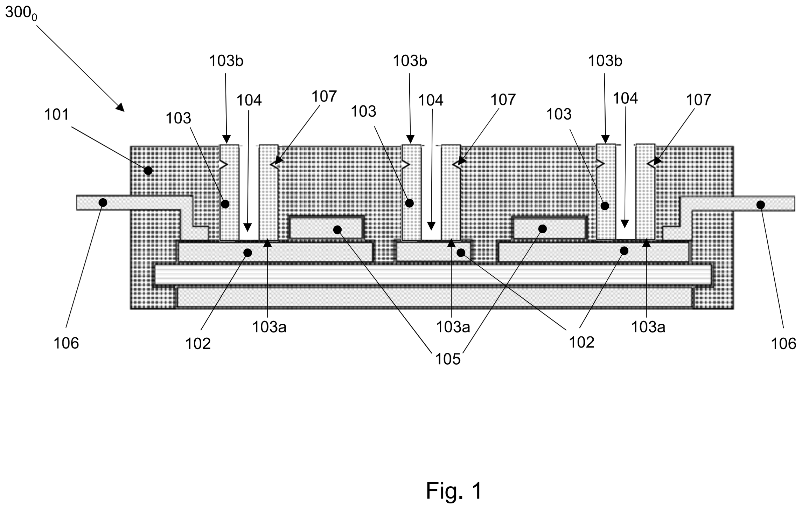

Fig. 1 depicts a moulded or encapsulated semiconductor package 300₀ without connection pins. Herein rivets 103 are provided on the semiconductor package, each rivet being electrically mounted with a first rivet end 103a on a corresponding bond pad 102. The rivets 103 are pillar-shaped and each comprise a circumferential groove 107 near the second rivet end 103b, and a rivet cavity 104, arranged for receiving a connection pin (not shown here). Herein the semiconductor package 300₀ comprises copper and ceramic electrically conductive layers, dies 105, leads 106, and a moulding compound 101 being an Epoxy Moulding Compound, EMC. The rivets 103 and the bond pad 102 are made of copper and are soldered with copper.

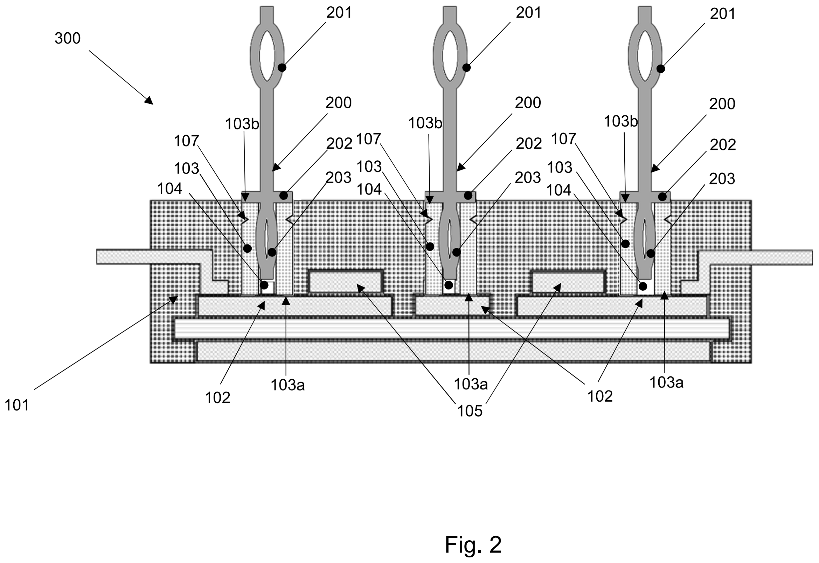

Fig. 2 depicts an encapsulated semiconductor package 300, comprising connection pins 200. The encapsulated semiconductor package 300 has the same design as the encapsulated semiconductor package 300₀. Each connection pin 200 has a pin tip 203 and a pin end 201, and is configured as a double press-fit pin. The pin tip 203 of the connection pin 200 has one hole-shaped sub-part having an outer width larger than an inner diameter of the rivet cavity 104. The pin end 201 of the connection pin 200 has also one hole-shaped sub-part. The connection pin 200 is coupled to the rivet 103 via the hole-shaped sub-part of the pin tip 203 inserted in the rivet cavity 104, and a collar 202 seated on the second rivet end 103b.

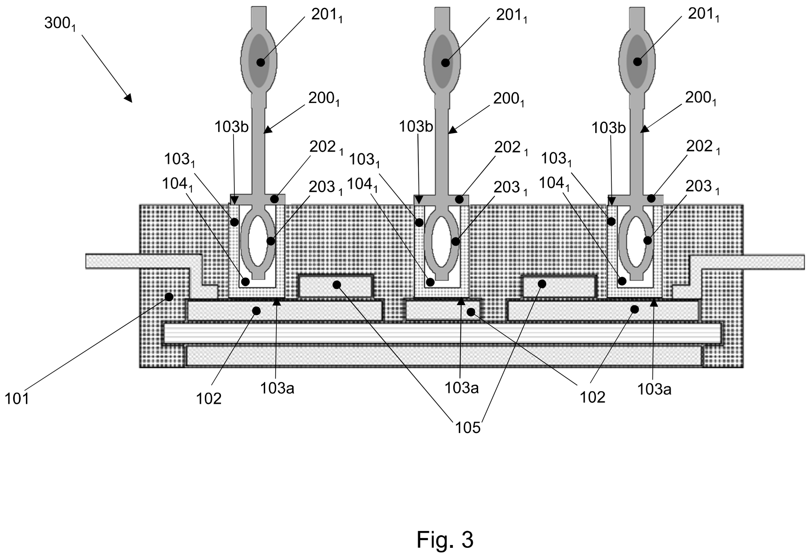

Fig. 3 depicts an encapsulated semiconductor package 300₁, comprising connection pins 200₁. The encapsulated semiconductor package 300₁ has the same design as the encapsulated semiconductor package 300₀, instead of a rivet 103₁ being configured as barrel shaped. Each connection pin 200₁ has a pin tip 203₁ and a pin end 201₁, and is configured as a double press-fit pin. The pin tip 203₁ of the connection pin 200₁ has one hole-shaped sub-part having an outer width larger than an inner diameter of the rivet cavity 104₁. The pin end 201₁ of the connection pin 200₁ has one pit-shaped sub-part. The connection pin 200₁ is coupled to the rivet 103₁ via the hole-shaped sub-part of the pin tip 203₁ inserted in the rivet cavity 104₁, and a collar 202₁ seated on the second rivet end 103b.

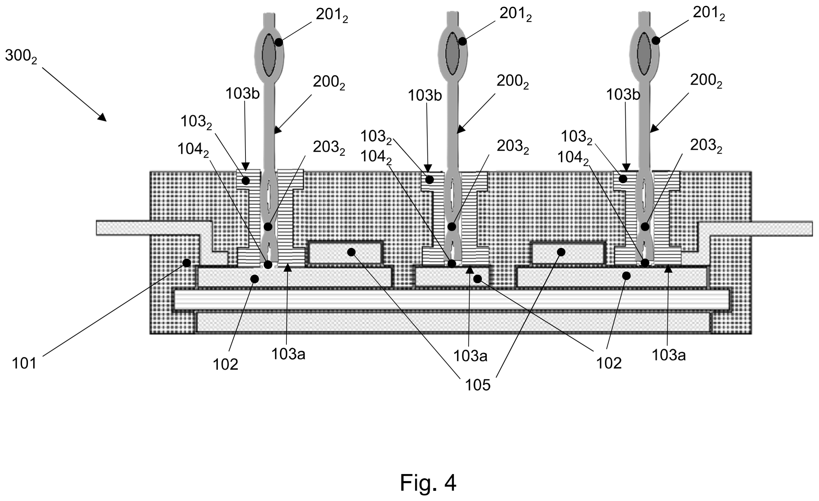

Fig. 4 depicts an encapsulated semiconductor package 300₂, comprising connection pins 200₂. The encapsulated semiconductor package 300₁ has the same design as the encapsulated semiconductor package 300₀, instead of a rivet 103₂ being configured as a double flat-head rivet. Each connection pin 200₂ has a pin tip 203₂ and a pin end 201₂, and is configured as a double press-fit pin. The pin tip 203₂ of the connection pin 200₂ has one hole-shaped sub-part and one bifurcated-shaped sub-part at the end of the pin tip 203₂. Both sub-parts have an outer diameter larger than an inner diameter of the rivet cavity 104₂. The pin end 201₂ of the connection pin 200₂ has one pit-shaped sub-part. The connection pin 200₂ is coupled to the rivet 103₂ via the hole-shaped sub-part and the bifurcated-shaped sub-part of the pin tip 203₂ inserted in the rivet cavity 104₂.

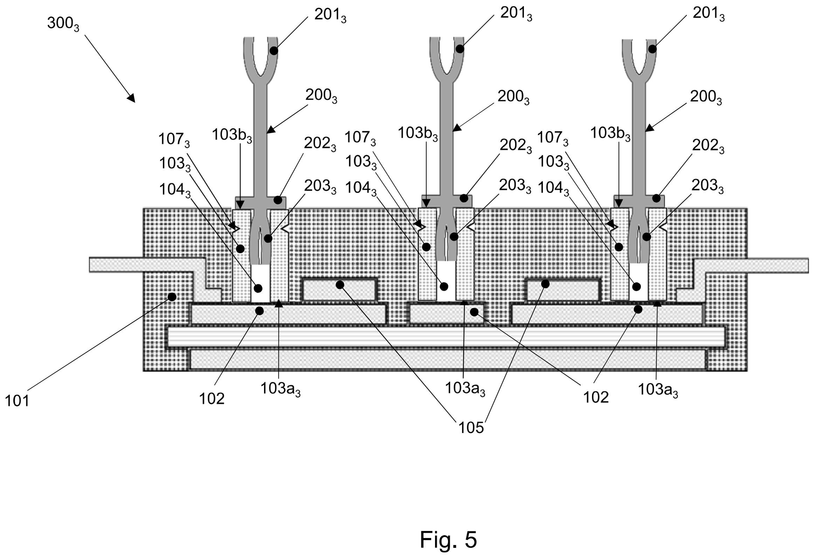

Fig. 5 depicts an encapsulated semiconductor package 300₃, comprising connection pins 200₃. The encapsulated semiconductor package 300₃ has the same design as the encapsulated semiconductor package 300₃. Each connection pin 200₃ has a pin tip 203₃ and a pin end 201₃, and is configured as a double press-fit pin. The pin tip 203₃ of the connection pin 200₃ has a bifurcated-shaped sub-part having an outer width larger than an inner diameter of the rivet cavity 104₃. The pin end 201₃ of the connection pin 200₃ has also a bifurcated-shaped sub-part. The connection pin 200₃ is coupled to the rivet 103₃ via the bifurcated-shaped sub-part of the pin tip 203₃ inserted in the rivet cavity 104₃, and a collar 202₃ seated on the second rivet end 103b₃.

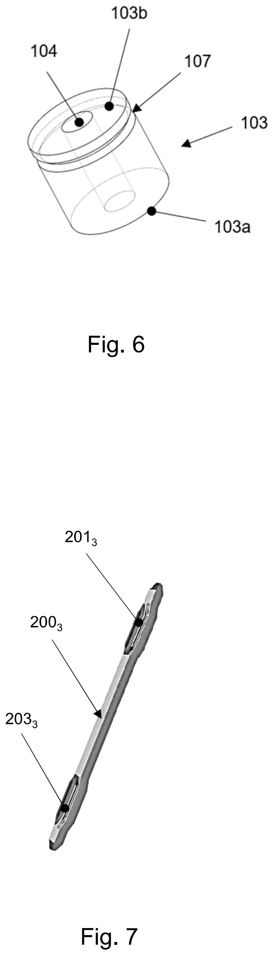

Fig. 6 depicts the rivet 103. The rivet 103 is pillar shaped with a circumferential groove near 105 the pin end below the top surface, and it is made of an electrically conductive material - copper - for providing an electrical connection between the bond pad and the connection pin. The rivet cavity 104 extends along the entire length of the rivet 103.

Fig. 7 depicts a connection pin 200₃ configured as a double press-fit pin with stamping-shaped pin end 201₃ and pin tip 203₃. This type of press-fit sub-part can also be used as a sub-part of the pin ends 201 and/or pin tips 203.

As noted above, particular terminology used when describing certain features or aspects of the disclosure should not be taken to imply that the terminology is being redefined herein to be restricted to any specific characteristics, features, or aspects of the disclosure with which that terminology is associated. In general, the terms used in the following claims should not be construed to limit the disclosure to the specific examples disclosed in the specification, unless the Detailed Description section explicitly defines such terms.

Accordingly, the actual scope of the disclosure encompasses not only the disclosed examples, but also all equivalent ways of practicing or implementing a preferred exemplary embodiment of the disclosure, it being understood that various changes may be made in the function and arrangement of elements, including combinations of features from different embodiments, without departing from the scope of the disclosure.

### LIST OF REFERENCE NUMERALS USED

- 101: moulding compound (encapsulant)
- 102: bond pad
- 103: rivet
- 103a: first rivet end
- 103b: second rivet end
- 104: rivet cavity
- 105: semiconductor die
- 106: lead
- 107: circumferential groove
- 200: connection pin
- 201: connection pin end
- 202: collar
- 203: connection pin tip
- 300n: semiconductor package (various examples)

## Claims

1. An encapsulated semiconductor package comprising :
a plurality of rivets, and a plurality of connection pins, each connection pin having a pin tip and a pin end,
wherein the plurality of rivets are disposed in the encapsulant of the encapsulated semiconductor package, each rivet having a first rivet end and a second rivet end, the rivet being electrically mounted with a first rivet end on a corresponding bond pad of the semiconductor package;
each rivet comprises a rivet cavity configured to receive the pin tip of the connection pin;
the pin tip of the connection pin is configured as a press-fit pin tip having an outer diameter larger than an inner diameter of the rivet cavity and configured for friction-based engagement with the rivet cavity.

2. The encapsulated semiconductor package in accordance with claims 1, wherein the pin end of the connection pin is configured as a press-fit pin.

3. The encapsulated semiconductor package in accordance with any of the claims 1-2, wherein the pin tip of the connection pin is configured as a press-fit pin with at least one hole-shaped sub-part and/or at least one bifurcated-shaped sub-part and/or at least one stamping-shaped sub-part and/or at least one pit-shaped sub-part.

4. The encapsulated semiconductor package in accordance with any of the claims 1-3, wherein the rivet is made of an electrically conductive material for providing an electrical connection between the bond pad and the connection pin.

5. The encapsulated semiconductor package in accordance with any of the claims 1-4, wherein the connection pin has a collar configured for abutment against the rivet.

6. The encapsulated semiconductor package in accordance with any of the claims 1-5, wherein the rivet is pillar shaped with a circumferential groove near the second rivet end.

7. The encapsulated semiconductor package in accordance with any of the claims 1-6, wherein the rivet is barrel shaped or configured as a double flat-head rivet.

8. The encapsulated semiconductor package in accordance with any of the claims 1-7, wherein the rivets and the bond pad are made of copper and the rivets are soldered to bond pad using a copper solder.

9. The encapsulated semiconductor package in accordance with any of the claims 1-8, wherein the semiconductor package has a moulding compound being an Epoxy Moulding Compound, EMC.

10. The encapsulated semiconductor package in accordance with any of the claims 1-9, wherein the semiconductor package comprises any of:
- Metal-Oxide-Semiconductor, MOS, Field-Effect-Transistor, FET;
- Bipolar, Junction, Transistor, BJT;
- Diode.
